# EUROPEAN PATENT APPLICATION

(11) **EP 1 898 666 A2**
(43) Date of publication of application: **12.03.2008**
(21) Application number: 07291069.8
(22) Date of filing: 05.09.2007
(51) Int. Cl.: H04R 19/01

(54) **Electret condenser microphone**

(30) Priority: 05.09.2006 KR 20060085180
(71) Applicant: BSE Co., Ltd., Namdong-gu Incheon 405-817 (KR)
(72) Inventor: Song, Chung-Dam, Seoul 157-801 (KR)
(74) Representative: Bloch, Gérard

(57) **Abstract**

Provided is an SMD type electret condenser microphone having a rectangular box shape, in which a curling process can be easily performed. In the electret condenser microphone, a pair of a diaphragm and a backplate is disposed to face each other, with a spacer being interposed therebetween. A conductive base electrically conducts the diaphragm, and an insulating base electrically insulates the backplate and the conductive base. A polar ring electrically conducts the diaphragm. A metal case has a rectangular box shape with one side open, such that the mechanical components are received. The metal case includes a curling surface, an edge portion of which is chamfered. Circuit components are mounted on a printed circuit board, which has a conductive pattern and a protruding connection terminal. A sealing pad is mounted on the insulating base to seal a gap between the metal case and the printed circuit board.

## Description

### BACKGROUND OF THE INVENTION

### Field of the Invention

The present invention relates to an electret condenser microphone, and more particularly, to a surface-mount-device (SMD) type electret condenser microphone having a rectangular box shape, which can be easily curled.

### Description of the Related Art

Condenser microphones are widely used in mobile communication terminals, audio equipment, etc. A typical condenser microphone includes a voltage bias element, a diaphragm/backplate pair configured to form a capacitance (C) varying with a sound pressure, and a junction field effect transistor (JFET) configured to buffer an output signal. Such a typical condenser microphone is fabricated by assembling a diaphragm, a spacer ring, an insulating ring, a backplate, a conductive ring, and a printed circuit board (PCB) within a case, and curling an edge portion of the case.

However, since defects occur during the process of curling the edge portion of the case, sound quality is degraded. Compared with a cylinder-shaped condenser microphone, a rectangular-box-shaped condenser microphone is easy to mount on a main board because it can easily recognize directionality of parts. However, the process of curling an edge portion of a case receiving parts is more difficult in the rectangular-box-shaped case than in the cylinder-shaped case.

### SUMMARY OF THE INVENTION

Accordingly, the present invention is directed to an electret condenser microphone that substantially obviates one or more problems due to limitations and disadvantages of the related art.

An object of the present invention is to provide an SMD-type electret condenser microphone having a rectangular box shape, in which a curling process can be easily performed by chamfering an edge of a rectangular-box-shaped case, and sound leakage caused by the chamfer can be prevented by using a sealing pad.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, there is provided a rectangular-box-shaped electret condenser microphone, including: a pair of a diaphragm and a backplate disposed to face each other, with a spacer being interposed therebetween; å conductive base for electrically conducting the diaphragm; an insulating base for electrically insulating the backplate and the conductive base; a polar ring for electrically conducting the diaphragm; a metal case having a rectangular box shape with one side open, such that the diaphragm, the backplate, the conductive base, the insulating base, and the polar ring are received, the metal case including a curling surface, an edge portion of which is chamfered; a printed circuit board on which circuit components are mounted, the printed circuit board including a conductive pattern and a protruding connection terminal; and a sealing pad mounted on the insulating base to seal a gap between the metal case and the printed circuit board.

The sealing pad may have a rectangular ring shape and may be formed of a flexible material, for example, rubber and resin. The curling surface of the case may be used as a connection terminal. The rectangular-box-shaped electret condenser microphone may further include a sound hole in a printed circuit board or a bottom surface of the case so as to receive an external sound.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:

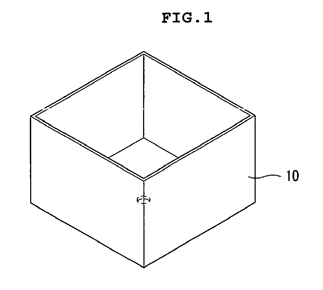

FIG. 1 is a perspective view of a case of a conventional rectangular-box-shaped condenser microphone;

FIG. 2 is a perspective view of a case of a rectangular-box-shaped condenser microphone according to an embodiment of the present invention;

FIG. 3 is a perspective view illustrating an assembled state of a rectangular-box-shaped condenser microphone according to an embodiment of the present invention;

FIG. 4 is a side sectional view of the rectangular-box-shaped condenser microphone illustrated in FIG. 3;

FIG. 5 is a perspective view of a sealing pad according to an embodiment of the present invention; and

FIG. 6 is a side sectional view of a rectangular-box-shaped condenser microphone according to another embodiment of the present invention.

### DETAILED DESCRIPTION OF THE INVENTION

Reference will now be made in detail to the preferred embodiments of the present invention, examples of which are illustrated in the accompanying drawings. Wherever possible, the same reference numbers will be used throughout the drawings to refer to the same or like parts.

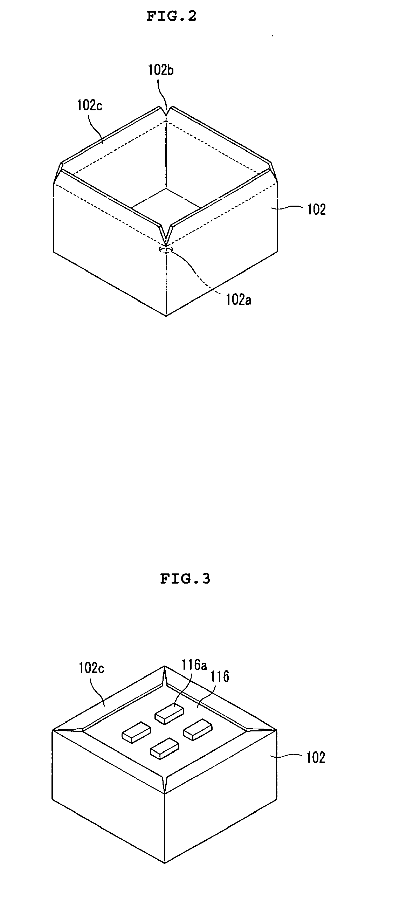

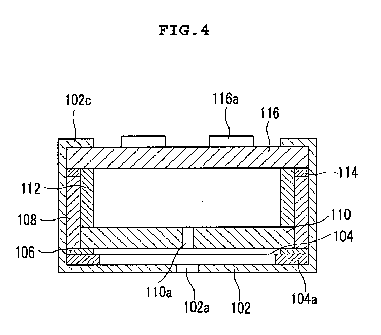

FIG. 2 is a perspective view of a case of a rectangular-box-shaped condenser microphone according to an embodiment of the present invention, FIG. 3 is a perspective view illustrating an assembled state of a rectangular-box-shaped condenser microphone according to an embodiment of the present invention, and FIG. 4 is a side sectional view of the rectangular-box-shaped condenser microphone illustrated in FIG. 3.

Referring to FIGs. 2 to 4, the rectangular-box-shaped condenser microphone includes a metal case 102, a polar ring 104a, a diaphragm 104, a spacer 106, an insulating base 108, a backplate 110 with a sound hole 110a, a conductive base 112, a rectangular-ring-shaped sealing pad 114, and a printed circuit board (PCB) 116. The metal case 102 has a rectangular box shape with one side open, such that parts are received therein. In the rectangular-box-shaped metal case 102, edge portions of curling surfaces 102c are chamfered for the purpose of easy curling. The polar ring 104a and the diaphragm 104 are built in the metal case 102. The rectangular-ring-shaped sealing pad 114 is used for preventing sound leakage. A conductive pattern and a protruding connection terminal 116a are formed in the PCB 116.

Referring to FIG. 2, the metal case 102 has a rectangular box shape with one side open, and four edges 102b of the open side are chamfered. Therefore, during the curling process, the end portions 102 of the adjacent surfaces do not overlap each other. The sound hole 102a is formed in the bottom surface of the case. The sound hole 102a may be formed in the PCB 116, instead of the case 102, depending on a sound entry structure of the condenser microphone.

The diaphragm 104 and the backplate 110 are disposed to face each other, with the insulating spacer 106 being interposed therebetween. The diaphragm 104 can be vibrated by external sound. The diaphragm 104 is electrically connected to the PCB 116 through the polar ring 104a and the metal case 102. The backplate 110 and the conductive base 112 are electrically isolated from the metal case 102 by the insulating base 108. Since such a structure has been well known to those skilled in the art, further description will be omitted.

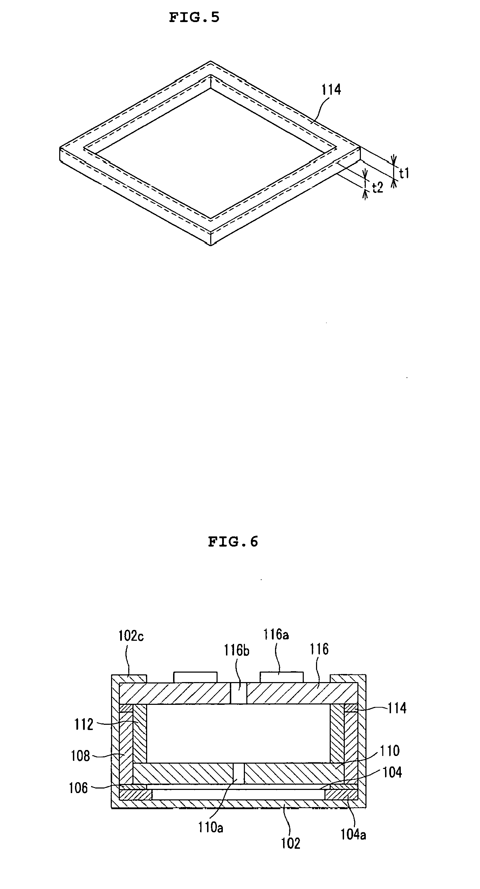

Referring to FIG. 5, the rectangular-ring-shaped sealing pad 114 prevents sound of the condenser microphone from leaking out. The sealing pad 114 is formed of a flexible material, for example, rubber and resin. The sealing pad 114 is mounted into the metal case 102 and then the PCB 116 is put into the metal case 102. Thereafter, when the metal case 102 is curled, the sealing pad 114 is pressed to seal the gap between the metal case 102 and the PCB 116. When the sealing pad 114 is pressed by the curling process, its height is reduced from t1 to t2.

As illustrated in FIG. 3, the condenser microphone assembled in the above-mentioned way can be easily curled because the edge portions 102c of the adjacent surfaces of the case 102 do not overlap one another. The protruding connection terminal 116a makes it easy to perform an SMD process. Two or more connection terminals may be formed in the PCB 116. The curling surface 102c of the case 102 may be used as a ground terminal.

FIG. 6 is a side sectional view of a rectangular-box-shaped condenser microphone according to another embodiment of the present invention.

Referring to FIG. 6, the rectangular-box-shaped condenser microphone includes a metal case 102, a polar ring 104a, a diaphragm 104, a spacer 106, an insulating base 108, a backplate 110 with a sound hole 110a, a conductive base 112, a rectangular-ring-shaped sealing pad 114, and a PCB 116. The metal case 102 has a rectangular box shape with one side open, such that parts are received therein. In the rectangular-box-shaped metal case 102, edge portions 102b of curling surfaces 102c are chamfered for the purpose of easy curling. The polar ring 104a and the diaphragm 104 are built in the metal case 102. The rectangular-ring-shaped sealing pad 114 is used for preventing sound leakage. A conductive pattern, a protruding connection terminal 116a, and a sound hole 116b are formed in the PCB 116.

A significant difference between the two condenser microphones is that the condenser microphone of FIG. 6 has the sound hole 116b in the PCB 116, while the condenser microphone of FIG. 4 has the sound hole 102a in the case 102. Further description about other elements will be omitted for avoiding the duplication.

As described above, the electret condenser microphone according to the embodiments of the present invention can be easily curled by chamfering the edge portions of the rectangular-box-shaped case. Furthermore, sound characteristics of the electret condenser microphone can be improved by sealing the gap between the case and the PCB using the sealing pad.

It will be apparent to those skilled in the art that various modifications and variations can be made in the present invention. Thus, it is intended that the present invention covers the modifications and variations of this invention provided they come within the scope of the appended claims and their equivalents.

## Claims

1. A rectangular-box-shaped electret condenser microphone, comprising:
a pair of a diaphragm and a backplate disposed to face each other, with a spacer being interposed therebetween;
a conductive base for electrically conducting the diaphragm;
an insulating base for electrically insulating the backplate and the conductive base;
a polar ring for electrically conducting the diaphragm;
a metal case having a rectangular box shape with one side open, such that the diaphragm, the backplate, the conductive base, the insulating base, and the polar ring are received, the metal case including a curling surface, an edge portion of which is chamfered;
a printed circuit board on which circuit components are mounted, the printed circuit board including a conductive pattern and a protruding connection terminal; and
a sealing pad mounted on the insulating base to seal a gap between the metal case and the printed circuit board.

2. The rectangular-box-shaped electret condenser microphone of claim 1, wherein the sealing pad has a rectangular ring shape and is formed of a flexible material, including rubber and resin.

3. The rectangular-box-shaped electret condenser microphone of claim 1, wherein the curling surface of the case is used as a connection terminal.

4. The rectangular-box-shaped electret condenser microphone of claim 1, further comprising a sound hole in a printed circuit board or a bottom surface of the case so as to receive an external sound.
